# NEUE EUROPÄISCHE PATENTSCHRIFT

(11) **EP 0 608 477 B2**
(45) Veröffentlichungstag und Bekanntmachung des Hinweises auf die Entscheidung über den Einspruch: **15.08.2007**
(45) Hinweis auf die Patenterteilung: 13.08.1997
(21) Anmeldenummer: 93113943.0
(22) Anmeldetag: 01.09.1993
(51) Int. Cl.: H03K 17/18, H03K 17/79, H01H 47/00

(54) **Halbleiterrelais**
Semiconductor relay
Relais semi-conducteur

(30) Priorität: 26.01.1993 DE 9301023 U
(43) Veröffentlichungstag der Anmeldung: 03.08.1994
(73) Patentinhaber: Carlo Gavazzi Marketing AG, 6312 Steinhausen (CH)
(72) Erfinder: Kristensen, Ove Stym, DK-8370 Hadsten (DK)
(74) Vertreter: Kehl, Günther

(56) Entgegenhaltungen:
- EP-A- 0 111 028
- EP-A- 0 176 800
- EP-A- 0 206 087
- EP-A- 0 226 174
- DE-A- 3 311 426
- DE-A- 4 137 048
- US-A- 4 188 547
- US-A- 4 298 810
- US-A- 4 924 344
- US-A- 4 931 778

## Beschreibung

Die Erfindung bezieht sich auf ein Halbleiterrelais, mit einem Steuereingang und einem durch einen Steuerstrom oder eine Steuerspannung betätigbaren Ausgangsleistungsschalter, der entsprechend einem an dem Relaissteuereingang anliegenden Steuersignal geöffnet oder geschlossen wird. Ein solches Halbleiterrelais wird bisweilen als SSR (Solid State Relay) bezeichnet.

Aus DE 41 37 048 A1 ist eine elektronische Überwachungs- und Sicherheitssteuerschaltung für einen Leistungsschalter bekannt. Bei der bekannten Schaltung wird über Optokoppler ein Eingangssteuersignal erfaßt und einer Auswerteschaltung zugeführt. Ferner wird bei der bekannten Schaltung die Spannung an einer Last abgegriffen. Falls bei fehlendem Eingangssteuersignal eine Spannung an der Last festgestellt wird, wird die Last durch eine Bypassleitung überbrücht, wodurch ein Kurzschluß ausgelöst wird, der zum Durchbrennen einer Sicherung und damit zum Unterbrechen des Laststromes führt. Nach in der genannten Schrift offenbarten Ausführungsvarianten wird der Laststrom über einen Sicherheitsschalter unterbrochen, wobei die Betätigung des Sicherheitsschalters über einen Optokoppler erfolgt.

Der Erfindung liegt die Aufgabe zugrunde, ein Halbleiterrelais zu schaffen, bei dem ohne die Verwendung von externen Überwachungsschaltungen die Leitungsspannung und der Zustand des Lastkreises überwacht werden. Die gesamte Schaltung soll sich durch kleine Bauweise auszeichnen.

Die Lösung dieser Aufgabe ist im Patentanspruche 1 angegeben.

Das erfindungsgemäße Halbleiterrelais ist in der Lage festzustellen, ob die Spannungsquelle eine Spannung liefert und daß der Lastkreis nicht unterbrochen ist, beispielsweise durch eine ausgebrannte Glühlampe oder eine durchgebrannte Heizung. Wenn die Betriebsbedingungen nicht in Ordnung sind, wird ein Alarmausgangssignal gegeben. Die Fühlerelemente bestehen aus optischen Isolatoren und sorgen gleichzeitig für eine elektrische Trennung zwischen der Steuerung und der Leitungs-Last-Seite.

Die Erfindung wird nachfolgend anhand von zwei in den Figuren schematisch dargestellten Ausführungsbeispielen näher erläutert. Es zeigt:
- Figur 1:: Ein Blockschaltbild mit einem Beispiel eines Ausgangsschaltkreises zur Verwendung bei einem Relais gemäß der Erfindung.
- Figur 2:: Ein Blockschaltbild eines weiteren Ausführungsbeispieles eines Ausgangsschaltkreises.
- Figur 3:: Ein Blockschaltbild eines Ausführungsbeispieles eines Steuerkreises zur Verwendung bei einem Relais gemäß der Erfindung.
- Figur 4:: Ein Blockschaltbild zur Erläuterung eines Anwendungsbeispieles des erfindungsgemäßen Relais.
- Figur 5:: Ein Funktionsdiagramm für das Anwendungsbeipiel der Figur 4.

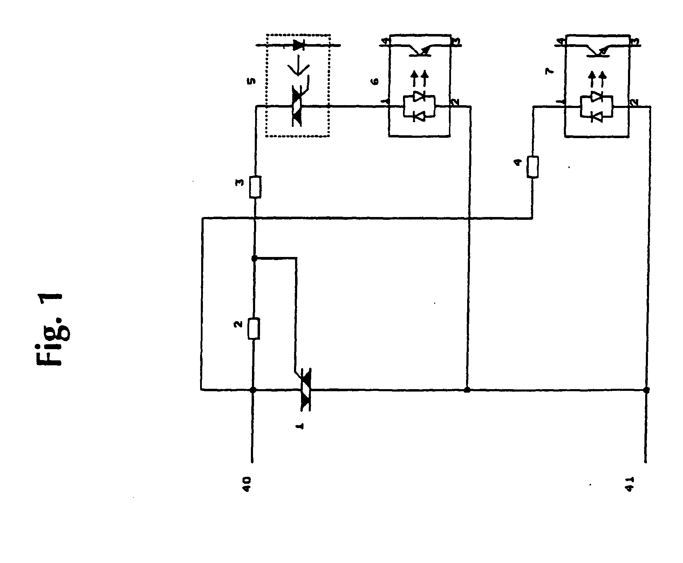

Figur 1 zeigt ein Beispiel eines Ausgangkreises für ein Halbleiterrelais gemäß der Erfindung. Der Steueranschluß eines zweidirektionalen Leistungsschalters 1 ist an einen optisch isolierten zweidirektionalen Schalter 5 über eine Strombegrenzungseinrichtung 3 und über den Eingang eines optischen Isolators 6 an den Leistungsausgangsanschluß 41 angeschlossen, sodaß ein Strom von dem Ausgangslastanschluß über eine Strombegrenzungseinrichtung 3 und den optischen Isolator 6, gesteuert durch den zweidirektionalen Schalter 5, fließen kann, um den Zustand des zweidirektionalen Leistungsschalters zu ändern. Der genannte Steuerstrom wird den optischen Isolator 6 nur dann aktivieren, wenn der Ausgangsleistungsschalter 1 sich in seinem leitenden Zustand befindet. Ein zweiter optischer Isolator 7 wird aktiviert, wenn eine Spannung an dem Ausgangsschalter infolge des über den Widerstand 4 fließenden Stromes vorhanden ist, der an den Ausgangsanschluß 40 angeschlossen ist.

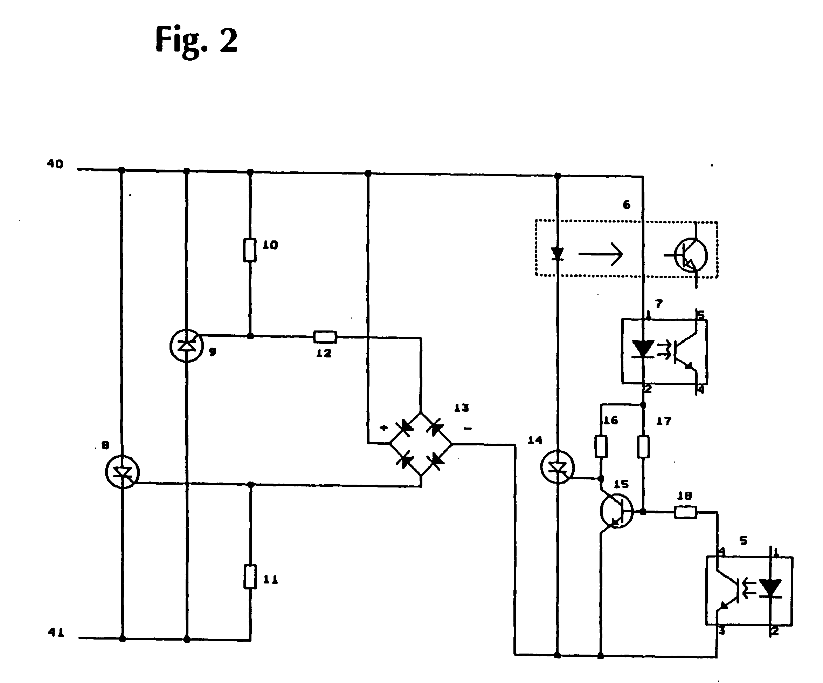

Figur 2 ist ein Blockschaltbild eines weiteren Ausführungsbeispieles einer Ausgangsschaltung für die Erfindung. Die Steueranschlüsse der beiden eindirektionalen Leistungsschalter 8 und 9 sind an die Wechselstromanschlüsse einer Gleichrichterbrücke 13 über eine Strombegrenzungschaltung 12 angeschlossen. Ein eindirektionaler Schalter 14 ist an den Plus-Eingang der Gleichrichterbrücke über den Eingang eines optischen Isolators 6 angeschlossen. Der Steueranschluß des eindirektionalen Schalters 14 ist an den positiven Anschluß der Gleichrichterbrücke 13 über einen Widerstand 16 und den Eingang eines optischen Isolators 7 angeschlossen. Der Kollektor des Transistors 15 ist an den Steueranschluß des eindirektionalen Schalters 14 und der Emitter ist an den negativen Anschluß der Gleichrichterbrücke 13 zusammen mit dem negativen Anschluß des eindirektionalen Schalters 14 angeschlossen. Der Basisanschluß des Transistors 15 ist über den Widerstand 17 und den Eingang des optischen Isolators 7 an den positiven Anschluß des Brückengleichrichters 13 angeschlossen. Der Basisanschluß des Transistors 15 ist auch über einen Widerstand 18 an den Ausgang eines optischen Schalters 5 angeschlossen. Der negative Ausgangsanschluß des optischen Schalters ist an den negativen Anschluß der Gleichrichterbrücke 13 angeschlossen. Angenommen, es liege nun eine Spannung an den Ausgangsanschlüssen 40 und 41 an. Diese Spannung wird durch die Gleichrichterbrücke 13 gleichgerichtet und erscheint als Gleichspannung an den Eingängen der optischen Schalter 6 und 7. Wegen der Widerstände 16 und 17 erzeugt die Gleichspannung einen Gleichstrom, der über den optischen Schalter 20 in die Basis und den Kollektor des Transistors 15 fließt. Der optische Schalter 7 wird dann aktiviert, wenn der optische Schalter 5 aktiviert ist und der Strom in der Strombegrenzungseinrichtung 17 fließt in den Ausgangsanschluß des optischen Schalters 5 durch die Strombegrenzungseinrichtung 18 anstatt in die Basis des Transistors 15. Unter diesen Bedingungen fließt der Strom durch den Widerstand 16 in den Steueranschluß des eindirektionalen Schalters 14 anstatt in den Kollektor des Transistors 15, sodaß der eindirektionale Schalter 14 aktiviert wird und den Strom durch den optischen Schalter 6 und die Gleichrichterbrücke 13, die Strombegrenzungseinrichtung 12 und in die Steueranschlüsse der eindirektionalen Leistungsschalter 8 und 9 führt, wodurch die Leistungsschalter aktiviert werden und zwar in Vorwärtsrichtung in Bezug auf die an den Eingangsanschlüssen 40 und 41 liegende Spannung.

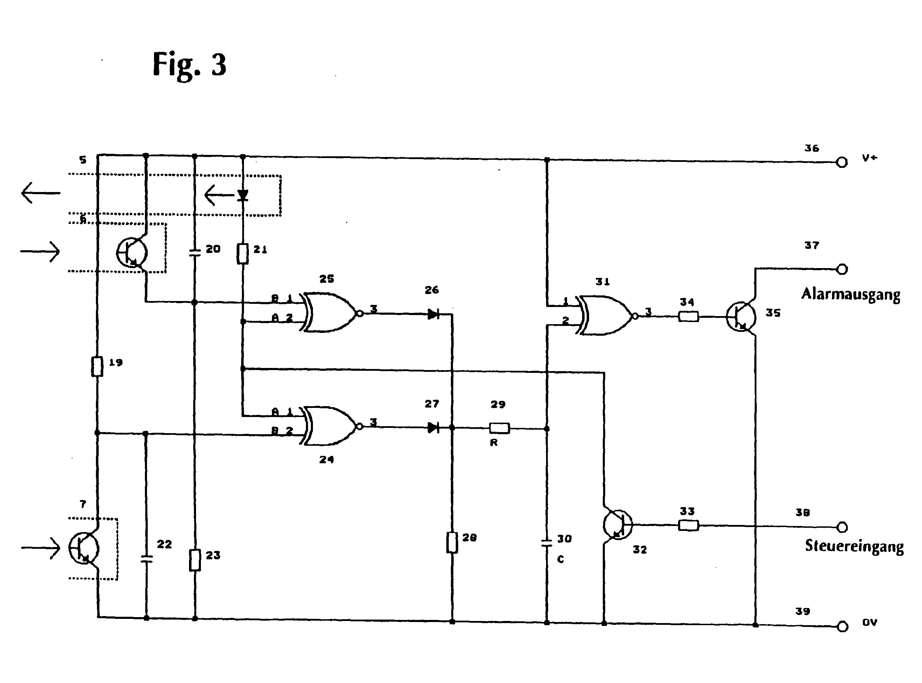

Figur 3 zeigt ein Blockschaltbild eines Ausführungsbeispieles einer Steuerschaltung für ein Halbleiterrelais gemäß der Erfindung. Die optischen Schalter in diesem Schaltbild stellen die Verbindung zwischen dieser Schaltung und den in den Figuren 1 und 2 erläuterten Schaltungen dar. In dieser Schaltung aktiviert der Transistor 32 den optischen Schalter 5 über einen Widerstand 21, wenn eine Steuerspannung an dem Steuereingang 38 anliegt. Gleichzeitig wird jeweils ein Eingang der Exklusiv-NOR-Gatter 24 und 25 von einer höheren Spannung auf eine niedrige umgeschaltet. Die Aktivierung des optischen Schalters 5 bringt die Ausgangsschaltung in den leitenden Zustand, wie dies in den Figuren 1 und 2 beschrieben ist. Dabei wird der optische Schalter 7 stillgelegt, weil keine Spannung an den Ausgangsanschlüssen 40 und 41 anliegt, wie dies im Zusammenhang mit den Figuren 1 und 2 erläutert wurde. Der optisch isolierte Schalter 6 wird durch den Strom aktiviert, der in den Steueranschluß des Ausgangsschalters fließt, wie dies in den Figuren 1 und 2 beschrieben ist.

Das bedeutet, daß jeweils der Eingang B der Exklusiv-NOR-Gatter 24 und 25 vom Zustand niedriger Spannung auf den Zustand höheren Spannung gebracht wird, weswegen die Ausgangsspannung der Gatter 24 und 25 Null wird. Auch das Exklusiv-NOR-Gatter 31 weist ebenfalls Null Volt Ausgangsspannung auf, weswegen der Alarmausgangsanschluß 37 nicht aktiv ist.

Wenn der Strom in dem Leistungsausgangsschalter, wie in Figur 1 und 2 beschrieben, unterbrochen wird, entweder durch Fehlen der Spannungsquelle oder durch Trennung der Last, wird der optisch isolierte Schalter 6 stillgelegt und der Eingang B des Gatters 25 ändert sich von einer höheren auf eine niedere Spannung, wodurch der Ausgang des Gatters 25 nach einer hohen Spannung wechselt. Diese Spannung lädt einen Kondensator 30 über einen Widerstand 29. Nach etwa 50 msec hat die Spannung an dem Kondensator 30 etwa 50% der Spannung V+ erreicht, wodurch das Gatter 31 den Ausgangszustand ändert und Strom durch den Widerstand 34 in die Basis des Transistors 35 fließt und somit der Alarmausganganschluß 37 aktiviert wird. Der Alarmausgang bleibt aktiviert, solange die fehlerhafte Bedingung besteht. Angenommen der Fehler wird beseitigt. Wenn die Spannung an dem Steuereingang beseitigt ist, wird der isolierte Schalter 5 stillgelegt und der Eingang A an den Gattern 24 und 25 wechselt auf eine hohe Spannung und gleichzeitig wird der optisch isolierte Schalter 6 stillgelegt, weil kein Steuerstrom zu dem Lastausgangsschalter wie unter Figuren 1 und 2 beschrieben, fließt. Des weiteren wird der optisch isolierte Schalter 7 aktiviert, weil eine Spannnung an den Ausgangsanschlüssen 40 und 41, wie in Figur 1 und 2 beschrieben liegt. Das bedeutet, daß die Spannungen an den Eingängen B der Gatter 24 und 25 einen Zustand niedriger Spannung annehmen und dadurch die Gatter 24 und 25 eine Ausgangsspannung erhalten, weswegen der Alarmausgang nicht aktiviert wird. Wenn die Spannung an den Eingangsanschlüssen 40 und 41 abgetrennt wird, entweder durch Fehlen einer Spannungsquelle oder durch Unterbrechung des Lastkreises, wird der optische Schalter 7 stillgelegt und der Eingang B des Gatters 24 nimmt einen Zustand hoher Spannung an, wodurch der Ausgang des Gatters 24 auf eine hohe Spannung kommt und der Kondensator 30 über die Diode 27 und den Widerstand 29 geladen wird, bis seine Spannung etwa 50% der Versorgungsspannung V+ annimmt. Bei dieser Spannung schaltet das Gatter 31 den Transistor 35 über den Widerstand 34 durch und somit den Alarmausgang ein.

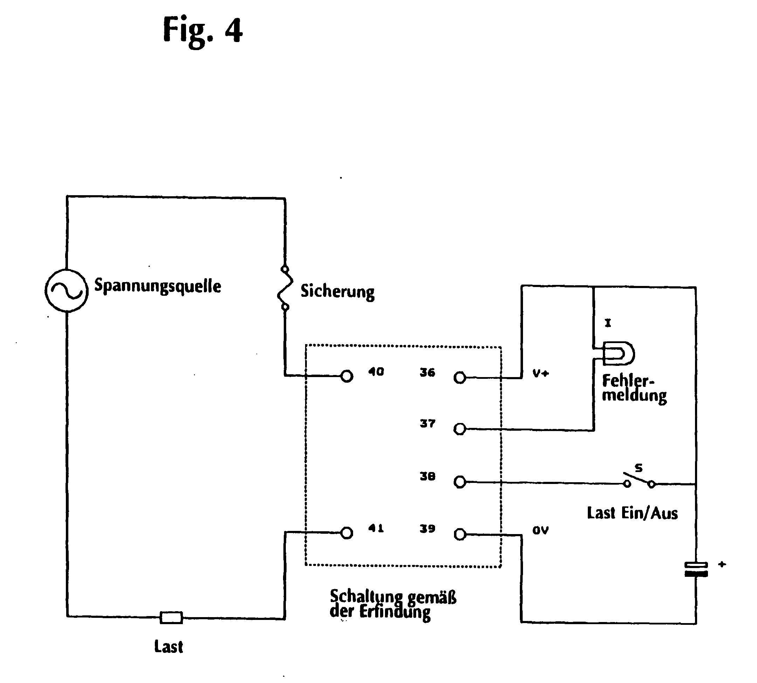

Figur 4 zeigt ein Bockschaltbild für die Anwendung des Ausführungsbeispieles des Halbtleiterrelais gemäß der Erfindung. Angenommen die Spannungsquelle sei die Netzspannung. Wenn der Schalter 5 geschlossen ist, wird der Ausgangsleistungsschalter des Halbleiterrelais gemäß der Erfindung, wie in Figuren 1 und 2 erläutert, geschlossen, sodaß Strom von der Spannungsquelle zu der Last fließen kann. Wenn der Schalter 5 wieder geöffnet wird, wird der Ausgangsleistungsschalter des Halbleiterrelais gemäß der Erfindung geöffnet. Wenn bei geöffnetem Schalter 5 die Spannungsquelle abgetrennt wird oder der Lastkreis ausfällt oder sich der Leistungsschalter des Relais nicht schließt, wird der Alarmsausgang 37 aktiviert, wie dies in den Figuren 1, 2 und 3 erläutert worden ist. Wenn bei geschlossenem Schalter 5 die Spannungsquelle abgetrennt wird oder der Lastkreis ausfällt oder der Ausgangsleistungsschalter gemäß der Erfindung sich nicht schließt oder sich schließt und dabei die Sicherung durchtrennt wird, wird das Alarmausgangssignal wie an Hand der Figuren 1, 2 und 3 erläutert, aktiviert.

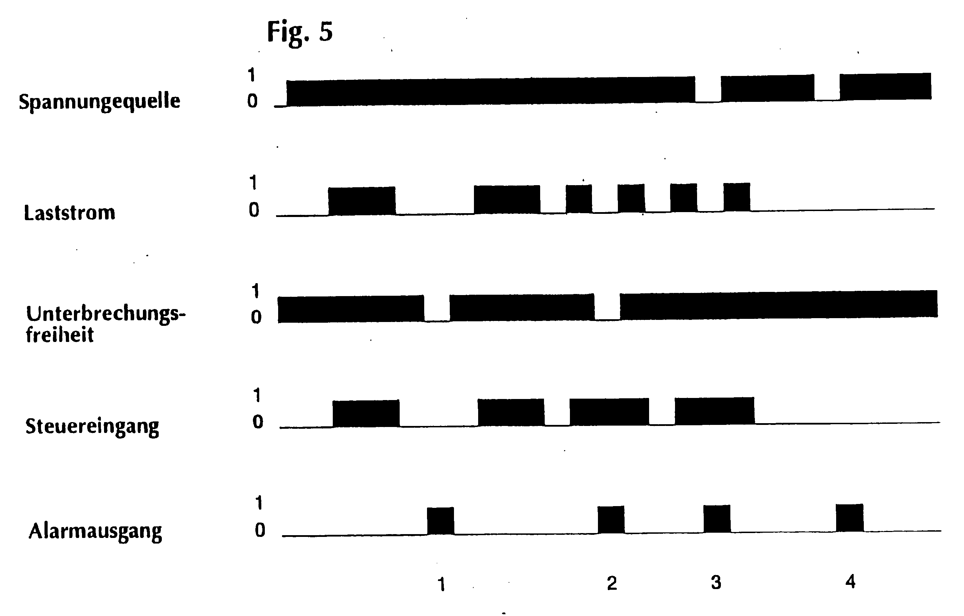

Figur 5 zeigt ein Funktionsdiagramm für die Anwendung des Ausführungsbeispieles der Figur 4.

### Alarmbeispiel 1 und 2:

Die Stromleitung durch die Last oder durch die Lastanschlüsse wurde unterbrochen.

### Alarmbeispiel 3 und 4:

Die Spannungsquelle ist ausgefallen.

## Patentansprüche

1. Halbleiterrelais mit einem Steuereingang (38) und einem durch einen Steuerstrom oder eine Steuerspannung betätigbaren Ausgangsleistungsschalter (1; 8, 9), der über einen galvanisch isolierten und magnetisch oder optisch gekoppelten Schalter (5) entsprechend einem an dem Relaissteuereingang (38) anliegenden Steuersignal geöffnet oder geschlossen wird, mit einer ersten mit dem Relais integrierten, den Steuerstrom oder die Steuerspannung für den Ausgangsleistungsschalter (1; 8, 9) erfassenden Fühlerschaltung, die einen magnetisch oder optisch gekoppelten Schalter (6) enthält und über diesen mit einer Auswerteschaltung(24-31) verbunden ist, mit einer zweiten die an dem Ausgangsleistungsschalter (1; 8, 9) anliegende Spannung erfassenden Fühlerschaltung, die einen magnetisch oder optisch gekoppelten Schalter (7) enthält und über diesen mit der Auswerteschaltung verbunden ist, wobei die Auswerteschaltung (24 bis 31), gegebenenfalls ein Alarmsignal liefert.

2. Halbleiterrelais nach Anspruch 1, **dadurch gekennzeichnet, daß** die Auswerteschaltung (24 bis 31) mit dem Relaissteuereingang (38) verbunden ist.

3. Halbleiterrelais nach einem der Ansprüche 1 bis 2, **dadurch gekennzeichnet, daß** die Auswerteschaltung zwei parallel geschaltete Exklusiv-NOR-Gatter (24, 25) enthält, deren Ausgänge miteinander verbunden sind.

4. Halbleiterrelais nach Anspruch 3, **dadurch gekennzeichnet, daß** der gemeinsame Ausgang der Exklusiv-NOR-Gatter (24, 25) mit einem integrierenden RC-Glied (29, 30) verbunden ist.

## Claims

1. Solid state relay having a control input (38) and a power output switch (1; 8, 9) activatable by a control current or a control voltage, said power output switch being opened or closed via a galvanically isolated and magnetically or optically coupled circuit (5) in accordance with a control signal applied to said relay control input (38), said solid state relay comprises a first galvanically isolated sensing circuit integrated with the relay and sensing the control current or the control voltage for the power output switch (1; 8, 9), and including a magnetically or optically coupled circuit (6) by which it is coupled to an evaluation circuit (24 to 31), a second galvanically isolated sensing circuit sensing the voltage across the power output switch (1; 8, 9), and including a magnetically or optically coupled circuit (7) by which it is coupled to an evaluation circuit (24 to 31), whereby the evaluation circuit (24 to 31) delivers an alarm signal as may be required.

2. Solid state relay according to claim 1, **characterized in that** the evaluation circuit (24 to 31) is coupled to the relay control input (38).

3. Solid state relay according to anyone of claims 1 to 2, **characterized in that** the evaluation circuit includes two Exclusive-NOR-gates (24, 25), connected in parallel, the outputs of which are coupled together.

4. Solid state relay according to claim 3, **characterized in that** the common output of the Exclusive-NOR-gates (24, 25) are coupled to an integrating RC-member (29, 30).

## Revendications

1. - Relais à semiconducteurs comportant une entrée de commande (38) et un interrupteur de puissance de sortie (1 ; 8, 9), qui peut être actionné par un courant de commande ou une tension de commande et qui est ouvert ou fermé par l'intermédiaire d'un interrupteur (5) isolé galvaniquement et couplé magnétiquement ou optiquement, en fonction d'un signal de commande appliqué à l'entrée (38) de commande du relais, avec un premier circuit de détection, qui est intégré au relais, détecte le courant de commande ou la tension de commande de l'interrupteur de puissance de sortie (1 ; 8, 9), qui contient un interrupteur (6) couplé magnétiquement ou optiquement et qui est relié par l'intermédiaire de celui-ci à un circuit d'exploitation (24 à 31), avec un second circuit de détection qui détecte la tension appliquée à l'interrupteur de puissance de sortie (1 ; 8, 9), qui contient un interrupteur (7) couplé magnétiquement ou optiquement et qui est relié par l'intermédiaire de celui-ci à un circuit d'exploitation, à l'occasion de quoi le circuit d'exploitation (24 à 31) délivre éventuellement un signal d'alarme.

2. - Relais à semiconducteurs selon la revendication 1, **caractérisé par le fait que** le circuit d'exploitation (24 à 31) est relié à l'entrée (38) de commande du relais.

3. - Relais à semiconducteurs selon l'une des revendications 1 à 2, **caractérisé par le fait que** le circuit d'exploitation comporte deux portes NON-OU-Exclusif (24, 25) branchées en parallèle, dont les sorties sont reliées entre elles.

4. - Relais à semiconducteurs selon la revendication 3, **caractérisé par le fait que** la sortie commune de la porte NON-OU-Exclusif (24, 25) est reliée à un circuit RC intégrateur (29, 30).
